# EUROPEAN PATENT SPECIFICATION

(11) **EP 3 053 688 B1**
(45) Date of publication and mention of the grant of the patent: **09.10.2019**
(21) Application number: 15154045.7
(22) Date of filing: 06.02.2015
(51) Int. Cl.: B23H 7/08, C23C 16/26

(54) **Graphene electrode and method of producing such electrode**
Graphenelektrode und Verfahren zur Herstellung einer solchen Elektrode
Électrode de graphène et procédé de fabrication d'une telle électrode

(43) Date of publication of application: 10.08.2016
(73) Proprietor: Agie Charmilles SA, 6616 Losone (CH)
(72) Inventor: Perez, Roberto, 1208 Genève (CH); Lyet, Denis, 74350 Andilly (FR)
(74) Representative: Fenner, Seraina

(56) References cited:
- EP-A1- 2 354 272
- US-A1- 2013 143 067
- DATABASE WPI Week 201379 Thomson Scientific, London, GB; AN 2013-R61676 XP002741834, & CN 103 127 919 A (UNIV BEIJING NORMAL) 5 June 2013 (2013-06-05)
- DATABASE WPI Week 201356 Thomson Scientific, London, GB; AN 2013-K92810 XP002741835, & KR 2013 0058389 A (KOREA ELECTRONICS TECHNOLOGY INST) 4 June 2013 (2013-06-04)
- CHOKKAKULA L: "A New Electrochemical Approach for the Synthesis of Copper-Graphene Nanocomposite Foils with High Hardness", SCI. REP., 11 February 2014 (2014-02-11), XP002741836,

## Description

The present invention relates to an electrode for electrical discharge machining (EDM) according to the generic part of claim 1. The invention relates in particular to wire electrodes, drilling electrodes or die-sinking electrodes.

Wire electrodes are commonly known and used in Wire electrical discharge machines (WEDM) for the machining of workpieces by electroerosion. The wire electrode is intended to cut the electrical conductive workpiece very precisely and constitutes an essential part for the EDM process. Wire electrodes have a brass, copper, or steel core and are covered by a coating to allow a higher electroerosion performance.

The performance of EDM wires for high-speed cutting is directly related to the electrical properties of the wire in terms of electrical conductivity, thermal conductivity and resistance to heat. The higher these conductivities and resistance are the more current and in a shorter time can be delivered by the sparks to the workpiece, allowing therewith an increased removal performance compared to conventional wires. Electrical conductivity, thermal conductivity and heat resistance are increased by providing an EDM wire with a suitable coating, which protects the wire also against thermal rupture. Thermal rupture is avoided by evacuating the heat generated by the sparks at the surface of a wire towards the core. Conventional high speed wires are based on Copper cores and Copper-Zinc alloy coatings or beta and gamma phase brass coatings. Up to date, no other material has shown to improve all the properties provided by these structures which are related to their performances for high speed cutting in WEDM's.
These coatings have the above-mentioned benefits for high removal of material and wire protection against heat. The incorporation of Copper in the coating increases its thermal resistance in respect of the occurring spark heat. Furthermore, as high power sparks favor also an undesired removal of the coating, high speed wires have usually thicker coatings than conventional wires in order to prevent any occurring removal during the electroerosion machining. Such coatings can also be made of alpha-phase brass in order to optimize the conduction of current and deliver high current peaks with high erosion potential during the discharge process. The core - often made of copper - is on the other hand also an essential part of the high speed EDM-wire, since high removal coatings have lower electrical and thermal conductivities which need to be compensated by the core of the wire.

The efforts to improve wire for EDM machining have been ongoing. The document US 4717804 discloses a wire made for instance of molybdenum or tungsten to which a carbon coating (graphite) is applied. The US 4740666 on the other hand discloses also a wire made of molybdenum or tungsten with an intermediate layer made of copper and zinc to which a carbon coating is adhered. The incorporation of graphite into coatings has been known particularly since graphite has been used as a material for producing die sinking electrodes.

The document US 20130119023 A1 discloses also a graphite coating of wire electrodes. The layer of graphite is metallurgically bonded to a core made of brass. The document claims improved electroerosion cutting performances based on the fact that graphite oxidizes during the electrical spark discharge and produces gaseous reaction products such as carbon monoxide and carbon dioxide. The graphite does consequently not produce any solid debris, which could disturb the electroerosion process as conventional standard coating materials, e.g. introducing conductive bridges in the gap, leading to short circuits, arcing and even wire breakage.

The document US 5030818 is also disclosing a wire electrode composed primarily of brass and copper alloys which include in their matrix graphite as second component with about 3 to 40 weight percent.

Further, it is also known in the state of the art to mix single-wall carbon nanotubes with dielectric fluids for EDM machining. Carbon nanotubes have a three-dimensional tubular structure and are mostly single-walled having a diameter of close to 1 nanometer. Such an application is published in the article "Analysis of surface characteristics of AISI D2 tool steel material using Electric Discharge Machining process with Single wall carbon nanotubes", (IACSIT Int. Journal of Engineering and Technology Vol. 2, No. 1, Feb. 2010, p. 35). Such carbon nanotubes can be produced for instance as explained in the document US 2008/0296147 A1. The Japanese patent application JP2004306162A discloses a micro electrode used for micro thermoforming which is coated with carbon nanotubes.

The US 2013/0143067 A1 discloses an electrode according to the preamble of claim 1, wires which are coated with a graphene layer and a method for manufacturing.

The present invention intends consequently to provide an improved, new coating of wire electrodes used in EDM applications.

The objective of the invention is achieved by providing an electrode wire for electroerosion machines according to the features of claim 1.

Graphene is a new material having outstanding properties in terms of thermal conductivity, electrical conductivity and thermal shielding. These properties are superior to those offered by copper and standard carbon structures like the graphite or the carbon nanotubes used by the state of the art. Incorporating this new material - graphene - at the surface of the wire increases all the required properties for high speed EDM cutting and that in an economical way with respect to all known conventional EDM coated and uncoated wires.

The advantages of graphene based coatings over conventional ones are related to the improved electrical conductivity of 30% with respect to copper reducing line resistance and Joule effect losses, allowing an increased peak current in shorter pulse on-times which lead to a significant higher efficiency cutting.

A second advantage is the improved thermal conductivity of graphene, which can be up 3 times of the known copper conductivity, which helps to spread and evacuate the thermal heat generated by the electric sparks towards the wire core and around the spark hot spot. Graphene based coatings reduce the thermal resistance of an electrode wire in respect to copper-zinc alloy coatings significantly, as graphene has a special carbon structure which is extremely resistant to heat. Hence, it will be less affected by the occurring thermal heat generated by the sparks at the hot spot. The electrode wear is therewith reduced same as the wire breakage probability.

While graphite used as coating in the state of the art has a three-dimensional structure - same as the carbon nanotubes which have also a three-dimensional and tubular form - the graphene of the inventive coating consists of a two-dimensional structure. The essential difference between graphene and graphite is that the latter, due to its structure, offers a comparably low thermal and electrical conductivity which doesn't contribute to any improvement neither in the conduction of current through the electrode nor to the dissipation of heat from the hot spot where a spark occurs.

Tests have shown that graphene can be deposited in a continuous layer over the surface of the wire, whereas carbon nanotubes will cover only partially the surface of the wire and need to be part of a composite in order to be applied on the wire core. The properties of resistance to heat of carbon nanotubes are significantly lowered with respect to a full graphene layer due to the fact that the covering with nanotubes is only partial and it is not possible to have a homogeneous full coating with nanotubes over the surface of the wire.

The improved performance of EDM electrodes with graphene coatings is a surprising effect, which is does not appear in conventional EDM coatings for high speed cutting. The remarkable effect of graphene coatings is that only a thin layer is necessary to improve the thermal conductivity at the surface of the wire. Conventional coatings have a substantially larger thickness on the wire core to meet the requirements of high power generators, in order to withstand the increased thermal load and wear produced at the hot spot during such high energetic processes. An observable effect of graphene coatings is that only a thin layer is necessary to improve the thermal conductivity at the surface of the electrode wire. This is due to the surprising fact that the improved thermal performance is actually produced in the metallic core of the wire (e.g. made of copper), which is in contact with the graphene coating. In fact, the extraordinary properties of a pure graphene layer, e.g. less than 1 micron, does not provide the measured conductivity properties observable with an inventive electrode wire. However, if such a thin layer of graphene, e.g. also less than 1 micron, is deposited as a coating around a metallic wire core, the resulting structure ends to be much more performing. This observation is confirmed by the article "Thermal properties of graphene-copper-graphene heterogeneous films" (Nano let. 2014, 14(3), p1497). These researches found out that the thermal conductivity of copper can be increased by 25% after coating graphene on its surface, not because of the graphene properties but because the deposition modifies the micro-structure of the underlying copper making the coated substrate thermal more conductive than normal pure copper substrates.

Apart of the improved thermal and electrical conductivity, coatings made of pure graphene or graphene-composites possess also superior mechanical properties compared to carbon nanotubes. The articles "Fracture and Fatigue in Graphene Nanocomposites," published in Small; "Enhanced Mechanical Properties of Nanocomposites at Low Graphene Content," published in ACS Nano; and "Buckling Resistant Graphene Nanocomposites," published in the journal Applied Physics Letters) show that graphene composites manifest better mechanical performances than carbon nanotubes composites, as a composites is "as weak as its weakest links", which in the case of carbon nanotubes coatings cracks and breakages are more likely to occur due to the reduced contact between the nanotube and the circumventing matrix.

In an embodiment of the invention, aiming to further increase the unexpected performance of a graphene coating on a metallic core, a supplementary coating on the top of the graphene layer can be applied. That supplemental coating can be - for instance - made of a Copper-Zinc alloy, with high Zinc content, or a composite Zn-graphene coating. The supplementary coating at the top of the graphene layer is introducing new properties to the wire electrode which are further improving the wires performance in terms of cutting speed.

Regarding the applicable composites used for producing such coatings with graphene as one component, the unexpected inventive effect than be observed even with very small graphene concentrations, e.g. below 1% in volume. This is enough to improve the mechanical resistance to fracture of the coating, which ultimately determines the resistance to breakage of the entire electrode wire. The observed inventive effect is surprising and cannot be obtained for instance with carbon nanotubes.

The improved thermal performance is consequently not just produced by the coating itself, as it occurs with conventional coatings, but by the observed synergetic effect of the metallic wire core combined with the graphene respectively graphene-composite coating.

Graphene can be used as pure coating material or can be combined as mentioned in a composite with other materials, for example with zinc, which, due to the low evaporation temperature, will add on beneficial effects for reduction of hot spot temperature, spark breakdown facilitation and increase of current density for an improved material removal rate at the machined workpiece, while reducing the wear and the thickness required for high speed cutting with respect to conventional copper-zinc based wire coatings .

In the following, the invention will be further explained by making reference to figures and possible embodiments. The invention is however not restricted to the embodiments and alternative illustrated, which are merely intended as incitement for the person skilled in the art to implement the invention in useful ways.

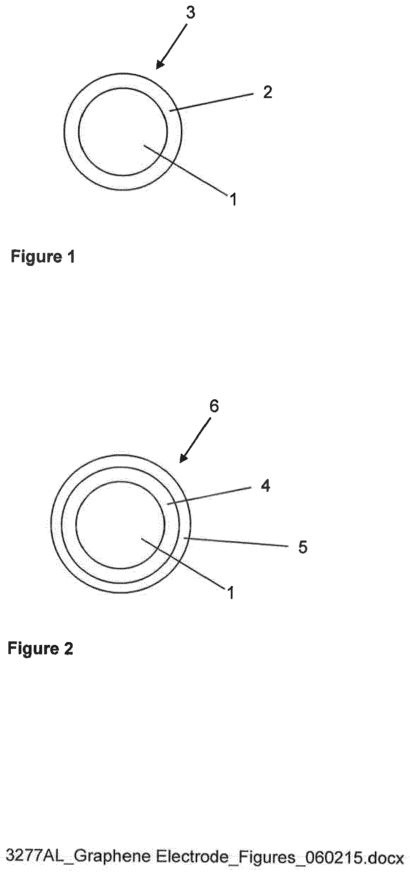

The figure 1 shows a cross section of a wire electrode 3. Its core 1 is made of copper, brass or steel and is covered with a coating 2 made of graphene or a composite of either graphene with Zinc, graphene with copper or a composite of graphene with both zinc and copper.

The figure 2 illustrates a wire electrode 6 according to the invention.

Here the core 1 is made of copper, brass or steel and covered with a first coating 4 made of Zinc or a Copper-Zinc alloy, and a second, external coating 5 made of graphene or a composite graphene-zinc or a graphene-zinc-copper composite. For the implementation of the invention, the electrode core made of copper, brass or steel will be covered with an inventive coating. The coating can be synthesized or deposited on the core by using an electrochemical process. A graphene coating can for instance be applied by such an electrochemical process, same as coatings made of zinc, zinc and graphene or made of copper and graphene.

Another possible embodiment of this invention is a copper or brass core with a first coating of copper-zinc alloy having higher zinc content than alpha brass, over which a graphene coating is synthesized or deposited using an electrochemical process.

In an alternative embodiment, the Copper or brass core is replaced with a steel core, over which a graphene coating is synthesized or deposited using an electrochemical process. Alternatively, a composite containing zinc and graphene or a composite containing zinc, copper and graphene might be used as coating material, also deposited by an electrochemical process.

Different methods are known to produce coatings made of graphene. Since the invention requires as a matter of fact only a thin graphene coating or a small concentration of graphene in a coating-composite, different possibilities exist in practice to manufacture such a coating on a metallic wire core, which do not belong to the known methods for manufacturing EDM wires.

Such a method is described for instance in the article "Graphene based materials and their composites as coatings" (Tong I., Austin J. Nanomed Nanotechnol. 2013; 1(1): 16). Graphene coatings can be for instance produced by Chemical Vapor Deposition (CVD). Further known methods for depositing graphene on a surface are for instance the sol-gel process or the electrophoresis process. An alternative method which can be used to produce composite coatings by electrochemistry is described in the article "A New Electrochemical Approach for the Synthesis of Copper-Graphene Nanocomposite Foils with High Hardness" (Chokkakula L, Sci. Rep. 2014/02/11). Therein graphene is incorporated into the electrolyte together with copper, whereby both components are deposited by electrochemical process on a surface.
It is a part of the invention to use those coating methods to apply a graphene coating on a wire core for manufacturing the inventive wire electrode. The use of these coating deposition methods makes the inventive wire electrode economic and competitive with respect to known electrode wires having conventional coatings according the state of the art.

Using for instance the CVD process to implement the invention, metallic wires are introduced in large sections in a CVD cell. In that cell, the metallic (core) wire is exposed to the CVD-process to deposit graphene on the wire surface until a desired thickness of the graphene-coating is reached. Since the necessary graphene layer is very thing - less than 1 micron - a continuous CVD-process can be used for industrial applications. Such a coating process would not be economical, if layers of 10 or more microns would have to be applied as necessary with ordinary coating materials.

By using the other mentioned methods for producing a graphene coating on a metallic wire, the sol-gel or the electrophoresis process (EPD), graphene is added to colloidal solution in which the wire is immerged. The solution with the wire is subsequently exposed to a thermal treatment in order to manufacture a solid coating on metallic surfaces. A simple EPD process is described by An et al. (J. Phys. Chem. Lett. 2010, 1, 1259-1263) and starts with commercially available graphene oxide solutions of 1.5 mg/ml (for instance available from Graphenea Inc., see http.-//www.graphenea.com/products/graphene-oxide) and which can be used for depositing layers up to several microns thick of graphene on metallic substrates, acting as electrodes and using voltages of 10-30 V for processing times of 1-5 minutes, followed by air drying. The process has the advantage of depositing and reducing simultaneously the graphene oxide into graphene with the suitable properties for the discharge machining. Such a process can be used for producing a coating on previously Zn or Cu-Zn alloy coated wires, followed by a wire drawing step which consolidates mechanically the graphene into the wire coating.

Similarly, such a small graphene concentration can be produced on a wire by electro-deposition in a zinc based bath, containing graphene platelets in suspension. For instance, a classic solution of 200 g/l zinc sulfate, 40 g/l sodium sulfate, 40 g/l boric acid, 1-4 g/l of graphene platelets and 2 g/l of cetyl trimethyl ammonium bromide as surfactant agent for maintaining the suspension during the process, would be sufficient to produce an inventive zinc-graphene composite coating with a of low graphene concentration on copper wires. The electro-deposition method is today used for the manufacturing of conventional zinc-coatings on wire electrodes. Thus it can be readily adapted to the deposition of zinc-graphene composites according to one of the inventive embodiments.

The before mentioned method disclosed in the article "A New Electrochemical Approach for the Synthesis of Copper-Graphene Nanocomposite Foils with High Hardness" can be for instance used for the deposition of composite coatings based on Copper-Zinc alloys on a EDM electrode wire.

The mentioned coating processes can also be combined respectively applied subsequently. This is done if an inventive electrode wire shall be manufactured as indicated in the foregoing text with two different coating layers.

The invention is not limited to the application to wire electrodes, but can be used for all kind of electrodes used in electrical discharge machines. The invention respectively the inventive electrode can be for instance a wire electrode, a drilling electrode or a die-sinking electrode. The inventive electrode has a core - preferably made of copper, brass, molybdenum, tungsten or steel - and which is covered by the inventive coating containing graphene.

According to the invention the coating is made of a composite also including zinc and/or copper.

Furthermore, the electrode has a supplemental first inner coating.

Preferably, that supplemental first inner coating is made of zinc or a copper-zinc alloy and the second external coating contains graphene, preferably a graphene-zinc composite or a graphene-copper-composite, most preferably a graphene-zinc-copper composite.

Most preferably, the coating containing graphene has a layer thickness ≤ 1 micron [10-6 m].

The coating containing graphene has a graphene concentration of ≤ 1 % in volume.

The present invention is not limited to the explicitly explained examples and embodiments. The illustrated alternatives are rather to be considered suggestions intended to motivate the person skilled in the art to implement the invention in a most favorable way.

### References

- 1: core of wire electrode
- 2: coating
- 3: wire electrode
- 4: first coating
- 5: second coating
- 6: wire electrode

## Claims

1. Electrode for electrical discharge machines, preferably a wire electrode (3), a drilling electrode or a die-sinking electrode, with a core (1), preferably made of copper, brass, molybdenum, tungsten or steel, and a coating (5), **characterized in that**
the coating (5) contains graphene wherein the coating (5) is made of a composite also including zinc and/or copper and has graphene concentration of ≤ 1 % in volume wherein the electrode (6) has a first inner coating (4).

2. Electrode for electrical discharge machines according to claim 1, **characterized in that**
the first inner coating (4) is made of zinc or a copper-zinc alloy and the second external coating (6) contains graphene, preferably a graphene-zinc composite or a graphene-copper-composite, most preferably a graphene-zinc-copper composite.

3. Electrode for electrical discharge machines according to one of the preceding claims, **characterized in that**
the coating (2, 5) containing graphene has a layer thickness ≤ 1 micron [10⁻⁶ m].

4. Manufacturing process for producing an electrode, preferably a wire electrode (3, 6), a drilling electrode or a die-sinking electrode, for electrical discharge machines according to one of the preceding claims,
wherein
the coating (2, 4, 5) is applied on the wire core (1) by an electrochemical process, preferably an electrolytic process **characterized in that** the process is a solgel or an electrophoresis process.

## Patentansprüche

1. Elektrode für Funkenerodiermaschinen, vorzugsweise eine Drahtelektrode (3), eine Bohrelektrode oder eine Senkelektrode, mit einem Kern (1), der vorzugsweise aus Kupfer, Messing, Molybdän, Wolfram oder Stahl hergestellt ist, und einer Beschichtung (5),
**dadurch gekennzeichnet, dass**
die Beschichtung (5) Graphen enthält, wobei die Beschichtung (5) aus einem Verbundwerkstoff hergestellt ist, der auch Zink und/oder Kupfer enthält, und eine Graphenkonzentration von ≤ 1 Vol.-% aufweist, wobei die Elektrode (6) eine erste innere Beschichtung (4) aufweist.

2. Elektrode für Funkenerodiermaschinen nach Anspruch 1, **dadurch gekennzeichnet, dass**
die erste innere Beschichtung (4) aus Zink oder einer Kupfer-Zink-Legierung hergestellt ist und die zweite äußere Beschichtung (6) Graphen, vorzugsweise einen Graphen-Zink-Verbundwerkstoff oder einen Graphen-Kupfer-Verbundwerkstoff, ganz besonders bevorzugt einen Graphen-Zink-Kupfer-Verbundwerkstoff, enthält.

3. Elektrode für Funkenerodiermaschinen nach einem der vorhergehenden Ansprüche, **dadurch gekennzeichnet, dass**
die Beschichtung (2, 5), die Graphen enthält, eine Schichtdicke von ≤ 1 Mikrometer [10⁻⁶ m] aufweist.

4. Herstellungsverfahren zum Herstellen einer Elektrode, vorzugsweise einer Drahtelektrode (3, 6), einer Bohrelektrode oder einer Senkelektrode, für Funkenerodiermaschinen nach einem der vorhergehenden Ansprüche,
wobei
die Beschichtung (2, 4, 5) durch ein elektrochemisches Verfahren, vorzugsweise ein elektrolytisches Verfahren, auf den Drahtkern (1) aufgebracht wird, **dadurch gekennzeichnet, dass** das Verfahren ein Sol-Gel- oder ein Elektrophoreseverfahren ist.

## Revendications

1. Electrode pour des machines de décharge électrique, préférablement un fil électrode (3), une électrode de perçage ou une électrode d'enfonçage, comportant un noyau (1), préférablement composé de cuivre, de laiton, de molybdène, de tungstène ou d'acier, et un revêtement (5),
**caractérisée en ce que**
le revêtement (5) contient du graphène, le revêtement (5) étant fait d'un composite comportant aussi du zinc et/ou du cuivre et possède une concentration en graphène ≤ 1% en volume, l'électrode (6) possédant un premier revêtement intérieur (4).

2. Electrode pour des machines de décharge électrique selon la revendication 1, **caractérisée en ce que** le premier revêtement intérieur (4) est composé de zinc ou d'un alliage cuivre-zinc et le deuxième revêtement extérieur (6) contient du graphène, préférablement un composite graphène-zinc ou un composite graphène-cuivre, le plus préférablement un composite graphène-zinc-cuivre.

3. Electrode pour des machines de décharge électrique selon l'une des revendications précédentes, **caractérisée en ce que**
le revêtement (2,5) contenant du graphène possède une épaisseur de couche ≤ 1 micron [10⁻⁶ m] .

4. Procédé de fabrication pour la production d'une électrode, préférablement d'un fil électrode (3, 6), d'une électrode de perçage ou d'une électrode d'enfonçage, pour des machines de décharge électrique selon l'une des revendications précédentes,
le revêtement (2, 4, 5) étant appliqué sur le noyau de fil (1) par un procédé électrochimique, préférablement un procédé électrolytique **caractérisé en ce que** le procédé est un procédé sol-gel ou un procédé d'électrophorèse.
